# EUROPEAN PATENT APPLICATION

(11) **EP 1 388 866 A1**
(43) Date of publication of application: **11.02.2004**
(21) Application number: 03017726.5
(22) Date of filing: 04.08.2003
(51) Int. Cl.: G11C 16/22

(54) **Electronic support device for the memorisation of data and data memorisation method adopting said device**

(30) Priority: 06.08.2002 IT UD20020175
(71) Applicant: Misa Srl, 33100 Udine (IT); RCH SpA, 31057 Silea (TV) (IT)
(72) Inventor: Spangaro, Giovanni, 33100 Udine (IT); De Pra, Luigi, 32100 Belluno (IT)
(74) Representative: Petraz, Gilberto Luigi

(57) **Abstract**

Electronic support device, of the card or electronic card type such as a memory card, for the memorization of data and method adopting the device. The electronic device is associated with an apparatus to acquire images, sounds or information of an alphanumerical type and comprises at least an electronic control unit (14), a memory (16) and an interface element (18). The memory (16) is divided into a plurality of sectors each comprising at least a first area dedicated to the memorization of data and at least a second area dedicated to controlling the state of the relative sector. The electronic control unit (14) addresses and writes the data to be memorized towards one or the other of the sectors and locks in definitive and non-erasable fashion the data memorized in the sector, preventing the rewriting thereof.

## Description

### FIELD OF THE INVENTION

The present invention concerns a stable and non-modifiable support device for the memorization of data, of the card or electronic card type, for example of the type known by the name of "flash memory card".

The support device according to the invention is able to be inserted into an apparatus to acquire images, sounds or information of an alphanumerical type, for example a cash register, a video camera, a digital camera, a portable computer, a device to control timetables and traffic, or a device applied to a means of transport to register data relating to the functioning of the means of transport, such as for example the black box for airplanes or a recorder for trucks or cars.

The support device according to the invention is not only suitable to memorize an extremely large quantity of data in an extremely small space, but also allows to block the data memorized in a definitive and non-erasable fashion and prevents new data from being rewritten in already occupied memory spaces.

This function of locking the data in a specific cell of memory is carried on by the same control circuit which manages the operation of writing the data itself in the cells of memory; this implies that this locking operation is safe and irreversible, i.e. when the cell of memory is full and the data are blocked, that specific cell of memory cannot be in any way re-written, and the data cannot be erased.

The device can therefore be preferentially applied in all those cases wherein accounting, tax, or administrative data is registered, or in any case data which has to be verified by bodies or officials to attest the validity of specific activities or that norms and procedures have been respected.

The invention also concerns a method with which the data is memorized and blocked in non-erasable fashion in said support device.

### BACKGROUND OF THE INVENTION

Devices for the memorization of data of the card or electronic card type are known, including those of extremely small size known as "flash memory cards", which are normally used in apparatus to acquire images, such as for example digital cameras, in order to memorize a large number of images and allow them to be downloaded, for example, into a computer, to be displayed and possibly processed.

Such memorization devices normally comprise a circuit including an electronic control unit, a memorization module, or memory, of variable capacity at present between 8 MB and 1 GB and more, organized in a plurality of sectors or cells, and an interface to connect the electronic control unit to a processing unit, commonly called "host system" of the apparatus.

The electronic control unit normally defines the methods in which the data is transmitted to the memory, and is able to detect whether each sector of memory is in a saturated condition or not, in order to address the new data either towards the same sector used previously or towards a new sector.

When the memory is in a saturated condition, or at any other instant, all or part of the already memorized data can be cancelled by a reset command, in order to have free space available again.

The cancellation of this data obviously entails the definitive loss, or at least the modification, of information which cannot be recovered.

Such conventional supports cannot therefore be used in association with any apparatus whose acquired data, for example for accounting, tax or certification reasons, must be neither cancelled nor modified after it has been memorized.

EP-A-1.143.455, on which is based the preamble of the independent claims, discloses a nonvolatile semiconductor memory device using flash EEPROM memories. This device includes two memory cell array blocks, and a plurality of block lock setting devices, for placing the second memory cell array block into a locked state in which a data write operation to and a data erasure operation from the second memory cell array block is prohibited.

In this document, however, the command to activate the locked state in the second array block is obtained by an external signal, such a floating gate MOS transistor or a latch circuit, usable at discretion. Moreover, the locked state is temporary and reversible, and the operation of locking a saturated cell block is not inherently obtained during the writing cycle.

US 2002/0065983 refers to a generic method for storing digital information by acquiring said information, storing it in a re-writable digital memory and storing part of the information in a write-once memory array. There is no indication of how to set a block of memory in a not-writable and not-erasable state in a definitive and irreversible way during a writing cycle.

The present Applicants have devised and embodied this invention to overcome the shortcomings of the state of the art and to obtain further advantages.

### SUMMARY OF THE INVENTION

The present invention is set forth and characterized in the respective main claims, while the dependent claims describe other innovative characteristics of the invention.

The purpose of the invention is to obtain an electronic support device for the memorization of data, which can be associated with an apparatus to acquire information in visual, audio or textual form, with which it is possible to lock and fix in an irreversible way the data in definitive and non-erasable fashion once it has been memorized. The purpose of the invention is to prevent the rewriting or modification of data on a memory space which is already occupied.

A support device according to the present invention comprises at least an electronic control unit, a memory module and an interface; the memory module is divided into a plurality of sectors, each comprising at least a first area dedicated to the memorization of data and consisting of one or more bytes, and at least a second area, consisting of one or more bits, dedicated to controlling the state of the relative sector.

The electronic control unit is able to address the data to be memorized towards one sector or the other.

According to one characteristic of the present invention, and in accordance with the above purpose, every time it receives a writing command, the electronic control unit fixes the memorized data in one sector, in a definitive and non-erasable fashion, preventing the rewriting thereof.

According to a variant, the electronic control unit first verifies the state of one sector of memory in use at that moment and, if the memory is full, chooses another memory sector.

If, on the contrary, the electronic control unit detects that the memory sector is at least partly free, it writes the data in that sector.

According to another variant, the electronic control unit determines, directly or on instructions from upstream, the sector to which the data to be definitively fixed is sent.

In a preferential embodiment of the invention, when a sector is recognized as having a full memory, and during the writing operation, the electronic control unit assigns to the control area of that particular sector an unalterable code to prevent the data from being rewritten and/or erased, so as to definitively, and in an irreversible way, block the data in that sector.

According to a variant, the electronic control unit provides on each occasion to block the data introduced.

The concept of "on each occasion" provides that the data is definitively frozen as it is gradually memorized, and also that the memorized data is definitively frozen periodically (in terms of time and length).

If the control area of every sector of memory is organized in memory cells of a binary type, one embodiment of the invention provides that, when a state of full memory is recognized, one specific bit is marked, for example switched from 0, which corresponds to a state wherein it is possible to write data in that sector, to 1; this marking prevents further writing and blocks the data in that sector of memory, making it un-erasable. The inverse passage from 1 to 0 of the control bit is prevented by the control circuit of the electronic control unit; therefore, when the control bit is marked to 1, this condition is irreversible and in no way that specific cell of memory can be re-write nor the data stored inside it can be erased. The blocking condition is therefore irreversible.

If all the sectors are marked with a non-rewriting code, the memorization support is no longer able to receive further data and information, nor to make a partial or total cancellation.

The memorization method which uses these supports therefore comprises at least a step during which the electronic control unit blocks the data in a sector by means of a corresponding non-rewriting marking in the corresponding control area.

An identical method, but applied on each occasion is provided if the information is frozen definitively on each occasion.

When the method provides to fix and block the data only when the sector is full, in the event that there is free memory, it provides a data memorization step until the memory of the sector in use is filled.

The sector may be saturated, according to the invention, either due to actual saturation or partial saturation in the event that the final information exceeds the residual capacity.

In this case the residual space is inhibited.

After blocking the data the method continues cyclically until all the data to be memorized has been inserted and blocked.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a schematic representation of an electronic memorization support device according to the invention;
- fig. 2 is a schematic representation of a memory module of the support in fig. 1;
- fig. 3 is a flow chart of the memorization method for the support device in fig. 1.

### DETAILED DESCRIPTION OF A PREFERENTIAL EMBODIMENT

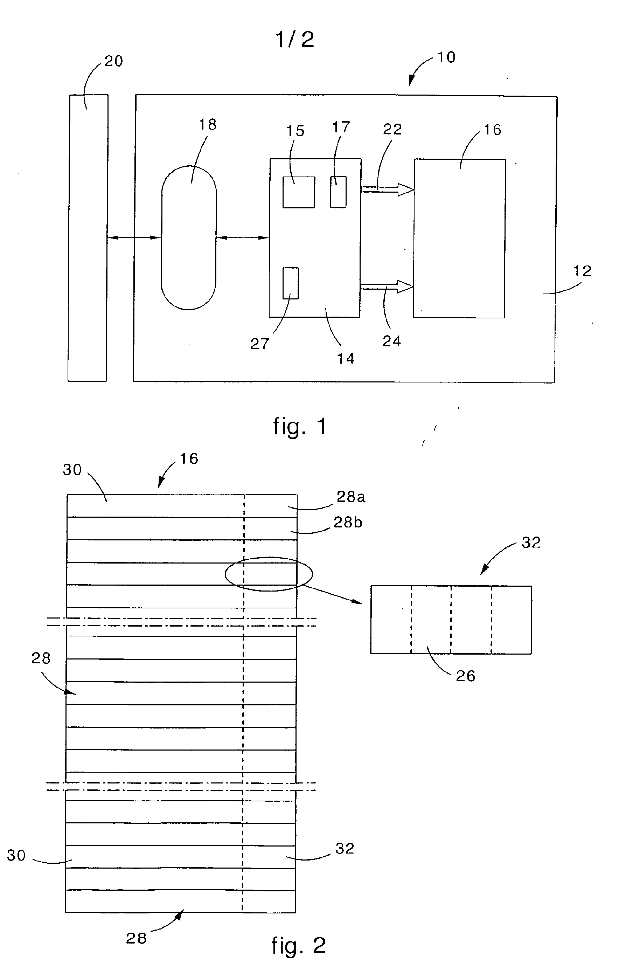

With reference to fig. 1, the number 10 denotes a support device for the memorization of data of the type known as "flash memory card".

The present invention can also be applied to similar or comparable memorization supports.

The device 10 is of the card or electronic card type and is able to be associated with an external processing unit 20, the so-called host computer of an apparatus, for example a cash register, or a video camera, to receive therefrom and memorize a large amount of data and information in an extremely limited space.

Other examples of apparatus which have an external processing unit 20, with which the device 10 can be associated, can comprise a fixed or portable computer, a palm-top, a videogame, a voice recorder device, an image scanner device, a satellite navigation device, or suchlike.

The support device 10 comprises as its essential parts a card 12, in the range of a few centimeters in size, supporting at least an electronic circuit consisting at least of an electronic control unit 14, a memorization module 16, or memory, of a non-volatile type (for example Flash Eprom), and an interface 18 which connects the electronic control unit 14 with the external processing unit 20.

The interface 18 can be implemented with a plurality of known protocols, such as for example serial universal buses, PCMCIA, ATA IDE and others.

The electronic control unit 14 comprises at least a CPU 15, a ROM 17 and an error signaling unit 27 and is connected in conventional fashion to the memorization module 16 by means of at least a data bus 22 through which commands are transmitted, for example writing or reading commands, addresses and data to be memorized.

There is also at least a control bus 24, able to transmit an identification code relating to the commands, addresses and data sent.

The memorization module 16, shown schematically in fig. 2, consists of memory cells organized in matrix form and defining a plurality of sectors 28 of a fixed length, for example 512 bytes, or other value considered appropriate.

Moreover, each sector 28 is in turn divided into at least two areas, a first 30 reserved for the memorization of data and a second 32 reserved for control.

According to a characteristic of the present invention, in the second area 32 at least one bit, in this case indicated by the number 26, is dedicated to controlling the state of the corresponding sector 28 in order to indicate whether in the relative first area 30 there is memory space available or not.

In a particular embodiment, for example, if the first sector 28a is full, the relative control bit 26 is codified by the control circuit with a marking, for example set to 1.

According to the invention, this marking not only indicates that there is no more memory space in the relative sector 28a, but also determines inherently the definitive and irreversible blockage of the memorized data and prevents said data being erased and/or new data rewritten in said sector 28a. The marking of the control bit to 1 is irreversible in the sense that the control algorithm prevents the inverse passage from 1 to 0.

This therefore inhibits the execution of a new writing or cancellation command to that sector 28a; such command is therefore sent to a second sector, for example sector 28b, including the relative control bit 26 which is not marked and is therefore set to 0.

The position of the sectors 28 concerned in the memorization may be sequential or may provide specific layouts according to requirements.

In this way, after the control bit 26 has been marked, only a reading command can be addressed to the first sector 28a, or in any case any command which does not involve the rewriting, modification or cancellation of the data memorized in that sector.

When all the sectors 28 have the control bit 26 set to 1, and hence the memorization module 16 has no more memory space free, either because it is saturated or because it is partly inhibited, the electronic control unit 14 prepares to send an error signal to the apparatus through the external processing unit 20, by means of the error signaling unit, or definitive saturation signaling unit 27, for every writing and cancellation command which it receives. When the error is shown, or other signal provided for this use, this indicates to the user that the support device 10 cannot contain any more new data and hence is available only for reading data contained therein.

The invention therefore embodies a memorization support 10 which can be written once only, cannot accept even partial cancellations and can be read many times.

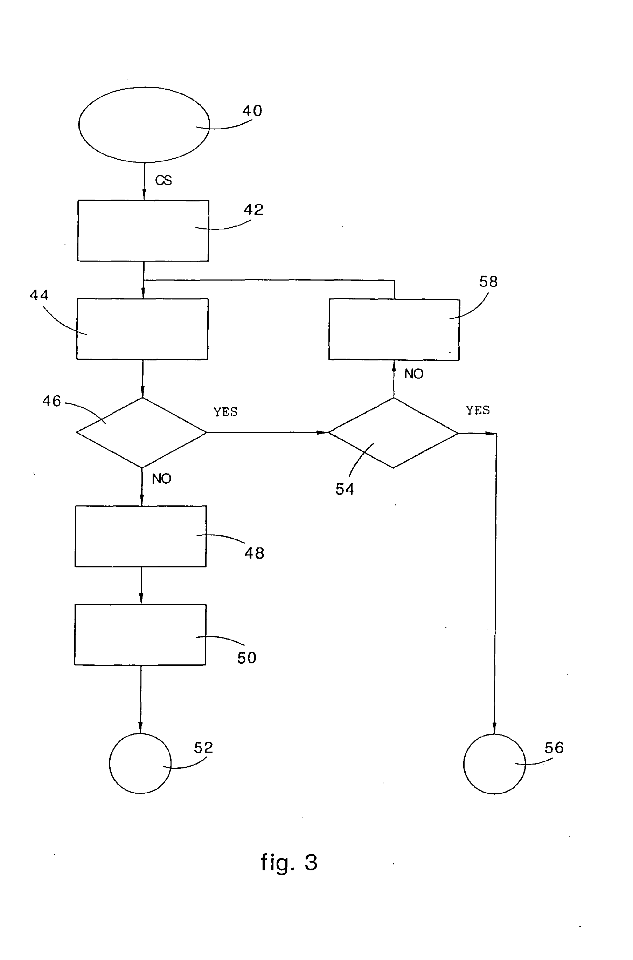

The diagram in fig. 3 shows a flow chart of the above.

In a first step 40, a writing command CS is imparted to the electronic control unit 14 by the external processing unit 20 on the data bus 22.

In a second step 42, the electronic control unit 14 determines the address of the first sector 28a where the data of the writing command CS is to be memorized, in a third step 44 the data is addressed to the control area 32 of the sector 28a and in a fourth step 46 the method controls if the sector 28a can receive new data, verifying whether the control bit 26 is marked or not.

If the first sector 28a has memory space available, in a subsequent step 48 another writing command CS is carried out, and this can be repeated until the available memory space is full.

When the last possible writing command has been carried out, the first sector 28a is marked in a step 50, by the control circuit and using the standard writing command, setting the control bit to 1, and the writing operation is concluded in a step 52.

If on the contrary, in step 46, the electronic control unit 14 detects that the control bit 26 is already set to 1, the method checks first of all, in a step 54, if all the sectors 28 have already been examined. In the event of a positive reply, there follows a step 56 during which it signals that the memorization support 10 is saturated; otherwise, there follows a step 58 in which the electronic control unit 14 addresses the writing command CS towards a new sector 28b. With this cycle, verification is obtained of all the sectors 28, and the data memorized is blocked definitively, thus imposing that the data cannot be erased or modified, and hence cannot be rewritten.

Modifications and/or additions of parts can be made to the support device 10 and the relative data memorization method as described heretofore, without departing from the field and scope of the present invention.

## Claims

1. Electronic support device for the memorization of data, able to be associated with an apparatus to acquire images, sounds or information of an alphanumerical type, said device comprising at least an electronic control unit (14), a memory (16) and an interface element (18), wherein said memory (16) is divided into a plurality of sectors (28) each comprising at least a first area (30) dedicated to the memorization of data and at least a second area (32) dedicated to controlling the state of the relative sector (28), said electronic control unit (14) being able to address and write the data to be memorized towards one or the other of said sectors (28), said device being of the card or electronic card type such as a memory card, **characterized in that** said electronic control unit (14) is able to lock in definitive, irreversible and non-erasable fashion the data memorized in said sector (28), preventing the rewriting thereof, said data locking operation being carried on by said electronic control unit (14) using the standard writing command.

2. Support device as in claim 1, **characterized in that** said electronic control unit (14) is able to verify the state of a sector (28) of memory in use at that moment and, if the memory is full, to block definitively the data present in the sector (28) in use, organizing the sending of subsequent data to another sector (28).

3. Support device as in claim 1, **characterized in that** said electronic control unit (14) is able to lock on each occasion the data sent to a sector (28).

4. Support device as in any claim hereinbefore, **characterized in that** said electronic control unit (14) is able to assign to the stably memorized part an unalterable code to prevent the data memorized from being rewritten and/or erased.

5. Support device as in any claim hereinbefore, **characterized in that** said second area (32) has at least a specific control bit (26) to which a determinate setting value is able to be assigned in correspondence with a non-full state of memory, and another setting value different from the first, in correspondence with a full state of memory, the inverse passage of the setting value from a condition of full state of memory to a condition of non-full state of memory being prevented by said electronic control unit (14).

6. Support device as in any claim hereinbefore, **characterized in that** said setting values are respectively 0 and 1.

7. Support device as in claim 2 and in any of claims from 4 to 6 inclusive, **characterized in that** when said setting value corresponding to the state of full memory is detected, said electronic control unit (14) is able to address the new data to be memorized towards a second of said sectors (28), until the memory of all said sectors (28) is full.

8. Support device as in any claim hereinbefore, **characterized in that** said electronic control unit (14) is provided with at least an error signaling unit (27) and that in correspondence with a state of full memory, said error signaling unit (27) is able to block memorization in the corresponding first area (30) of each of said sectors (28).

9. Support device as in claim 8, **characterized in that** said error signaling unit (27) is able to send a saturation message when all the sectors (28) are full.

10. Support device as in any claim hereinbefore, **characterized in that** the memory (16) is of the non-volatile type, of the "Flash Eprom" type.

11. Method for the memorization of data in a support device able to be associated with an apparatus to acquire images, sounds or information of an alphanumerical type, said device comprising at least an electronic control unit (14), a memory (16) and an interface element (18), wherein said memory (16) is divided into a plurality of sectors (28) each comprising at least a first area (30) dedicated to the memorization of data and at least a second area (32) dedicated to controlling the state of the relative sector (28), said electronic control unit (14) being able to address and write the data to be memorized towards one or the other of said sectors (28), said device being of the card or electronic card type such as a memory card, **characterized in that** it comprises a step of blocking (52) the memorized data by means of a corresponding marking to prevent rewriting of the data, said data blocking operation being carried on by the control circuit of the electronic device using the standard writing command.

12. Method as in claim 11, **characterized in that** said electronic control unit (14) verifies whether said first area (30) of a first (28a) of said sectors (28) is full and, if the memory is full, provides to block (52) the data in the first sector (28a) by marking the second control area (32).

13. Method as in claim 11, **characterized in that** said electronic control unit (14) provides to block (52) the data memorized on each occasion.

14. Method as in any claim from 11 to 13 inclusive, **characterized in that** it comprises a cyclical step of writing and memorizing (48) data until the memory of one sector (28) is full.

15. Method as in any claim from 11 to 14 inclusive, **characterized in that** after the blocking step (52) to prevent the rewriting of the data, the electronic control unit (14) addresses the new data to be memorized after having first verified the state of the memory.

16. Method as in any claim from 11 to 15 inclusive, **characterized in that** it comprises an error signaling step (56) in which, when said electronic control unit (14) detects a marking to prevent the data being rewritten and erased for all sectors (28), it sends a signal that said support device (10) is completely saturated.
